Europäisches Patentamt

European Patent Office

Office européen des brevets

(11) Publication number: **0 555 689 A2**

# EUROPEAN PATENT APPLICATION

(21) Application number: **93101190.2**

(22) Date of filing: **27.01.93**

(51) Int. Cl.5: **H03D 7/16**

(30) Priority: **11.02.92 EP 92400368**

(43) Date of publication of application:
**18.08.93 Bulletin 93/33**

(84) Designated Contracting States:
**DE ES FR GB IT**

(71) Applicant: **THOMSON CONSUMER
ELECTRONICS S.A.
9, Place des Vosges, La Défense 5
F-92400 Courbevoie(FR)**

(72) Inventor: **Howson, Christopher
26, rue Kageneck
F-67000 Strasbourg(FR)**
Inventor: **Haquet, Gérard
22 av. Malraux
F-67400 Strasbourg(FR)**
Inventor: **Guo, Chaoying
5, rue de Franche-Comté
F-67400 Illkirch(FR)**
Inventor: **Fujimoto, Masahiro
20, rue Constant Strohl
F-67000 Strasbourg(FR)**

(54) **Arrangement for downconverting microwave signals.**

(57) 2.1 It is an object of the present invention to downconvert SHF signals, especially in the 22 GHz band, by means which are already on the market and not too expensive.

2.2 According to the invention the SHF signals are double converted or a subharmonic mixer can be used.

2.3 The invention can preferably be used for 22 GHz DBS systems.

FIG.1

The present invention relates to an arrangement for downconverting microwave signals according to the generic part of claim 1 and according to the generic part of claim 5.

For the reception of microwave signals downconverters are well known, e.g. as part of a so called Direct Broadcasting Satellite (DBS) reception system.

Nowadays DBS signals are in the frequency band of 12 GHz and according components, such as High Electron Mobility Transistors (HEMT), are mass produced and of low-cost.

According to the article of K. Imai and H. Nakakita "A 22-GHz-Band Low-Noise Down-Converter for Satellite Broadcast Receivers", IEEE TRANSACTIONS ON MICROWAVE THEORY AND TECHNIQUES, Vol 39, 6. June 1991, the band 22,5 - 23,0 GHz was allotted to ITU Regions 2 and 3 for direct-to-home satellite broadcast services by the World Administrative Radio Conference (WARC) in 1979. The band is expected to be used for new media services such as integrated services of digital broadcasting (ISDB) and digital high-definition TV (HDTV) in the future.

In said article a low-noise down-converter has been presented, in which commercially available semiconductors and dielectric materials for 12 GHz band direct-to-home broadcast receivers have been employed.

For the realization of the downconverter of said article an expensive local oscillator with a frequency of 21,4 GHz is used and expensive assembly techniques with chip devices and wire bonding are necessary.

It is an object of the present invention to reduce the costs of a downconverter by employing only devices, especially packaged devices, which are already commercially available for a mass-market.

This can be realized by arrangements according to claim 1 and according to claim 5.

According to a first solution, a microwave downconverter, especially for signals in the 22 GHz band, is provided with a first mixer to which according local oscillator signals are led and which converts the received signals into a first intermediate frequency band. Additionally a second mixer is provided to which according second local oscillator signals are led and which converts signals of the first intermediate frequency band into a second intermediate frequency band.

By using double conversion the image frequency, which must be filtered out, is not so close to the signal frequency compared to a downconverter with a single conversion. Thereby the severity of the image rejection filtering requirement can be reduced enabling the band-pass filter to be realized as a parallel coupled microstrip line design printed on a teflon-glass substrate. Such a filter requires no through-holes, no added components and no post-manufacture alignment.

If the frequency of the first intermediate frequency band lies within the 12 GHz DBS frequency range, for the second mixer a device normally used for 12 GHz DBS systems can be taken and the costs of the downconverter according to the invention can be reduced in a larger extent.

For both mixers local oscillator signals with essentially the same frequency may be taken. This can be realized by using two local oscillators which generate signals in the same frequency range.

It is also possible to use just one oscillator from which both local oscillator signals are derived. This is a further step for reducing the production costs.

In a second solution there is just one mixer provided which is realised as subharmonic mixer. Thereby it is just necessary to use a single mixer for generating signals which can be processed by commercially available components.

Especially in those cases in which the downconverter is used for received DBS signals in the band of 22 GHz, which may also include the range 20 - 25 GHz, it is possible to realise low-cost, low-noise downconverters for home installation. In this case the second intermediate frequency is suitable for input to an according indoor unit. It is possible to use only packaged devices that are already commercially available for the 12 GHz DBS market, mounted on a single copper-clad teflon-glass substrate using reflow solder techniques compatible with mass production.

Further characteristics, details, and advantages of the invention will be explained in the followings embodiments with the aid of the drawings, where

Fig. 1    shows a block diagram of a first embodiment with doubleconversion;

Fig. 2    shows a circuit diagram of the embodiment of fig. 1;

Fig. 3    shows a block diagram of a second embodiment with a subharmonic mixer;

Fig. 4    shows a circuit diagram of the embodiment of fig. 2.

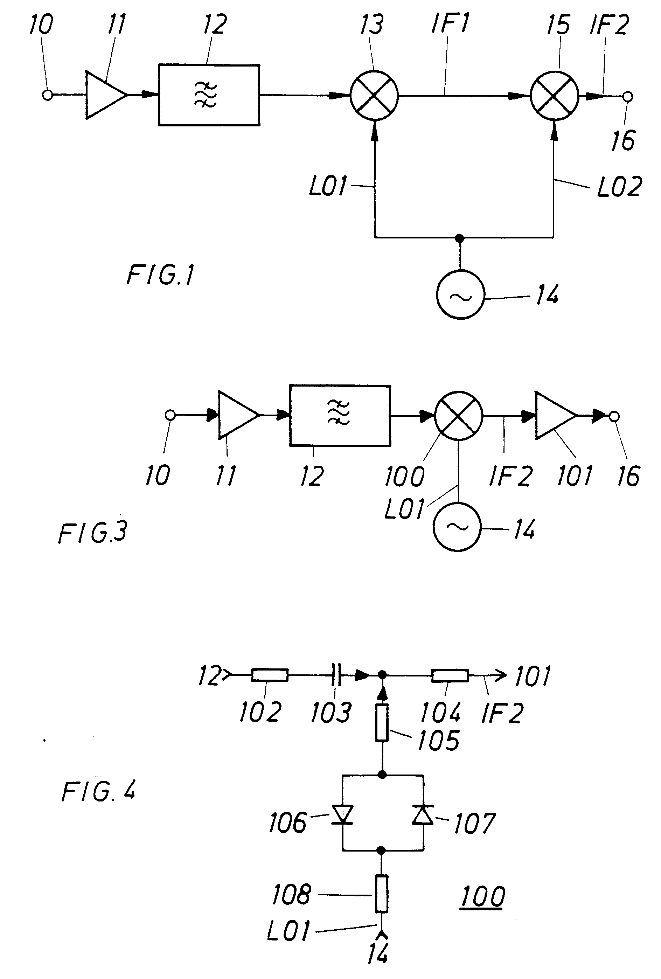

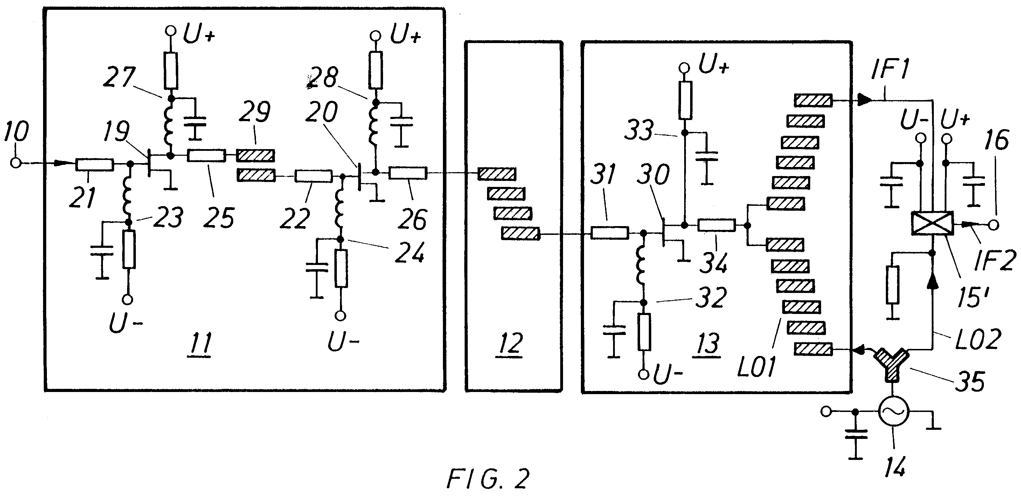

Fig. 1 shows a block diagram of a preferred embodiment. A received microwave signal in the frequency range

21,4 - 22 GHz

is led via the input terminal 10 to the input of a low noise amplifier (LNA) 11. The output signal of the LNA 11 is connected via a first bandpass filter 12 to a first mixer 13. The mixer 13 is also fed with a first local oscillator signal LO1 with a frequency

10,15 GHz,

which is generated by a local oscillator 14. The oscillator 14 can be realised as a dielectric resonator oscillator (DRO).

The output of the mixer 13 is a first intermediate frequency signal IF1 in the range

11,25 - 11,85 GHz,

which falls within the range of components for 12 GHz DBS products.

The signal IF1 is led to a second mixer 15, which can be realised as part of a GaAs monolithic microwave integrated circuit (MMIC). This product, in a TO-5 package, is marketed for 12 GHz DBS converters. In this embodiment the local oscillator signal (LO2) for the mixer 15 is also generated by the local oscillator 14. The output IF2 of the second mixer 15 is in the range

1,10 - 1,70 GHz

and can be led via an output terminal 16 to not shown receiving means, e.g. indoor units of a DBS system.

Fig. 2 shows a circuit diagram of a downconverter according to the block diagram of fig. 1. The LNA 11 includes two High Electron Mobility Transistors (HEMT) 19, 20. Each of the gates of the HEMTs 19, 20 is connected as well to a matching circuit 21, 22 respectively, as to a network 23, 24 respectively, each including a printed inductor, a resistor and a capacitor. The capacitors are connected to ground and the resistors are connected to a negative voltage U-.

Each of the drains of the HEMTs 19, 20 is connected to a matching circuit 25, 26 and to a network 27, 28 respectively, each including a printed inductor, a resistor and a capacitor. These capacitors are connected to ground and these resistors are connected to a positive voltage U + .

Between the matching circuits 25 and 22 a printed capacitor 29 is provided for blocking a DC voltage.

The first bandpass filter 12 is realised as a two-section parallel coupled microstrip line bandpassfilter. Such a filter requires no through-holes, no added components and no post-manufacture alignment. The measured insertion loss for the two-section filter over the 22 GHz band was 0,5 dB, with a return loss of greater than 17 dB.

The first mixer 13 includes a mixer-transistor 30, which is realised in this embodiment as HEMT, the gate of which is coupled to a matching circuit 31 and a network 32, including a printed inductor, a resistor, and a capacitor. The capacitor is connected to ground and the resistor is connected to the negative voltage U-. The drain of HEMT 30 is connected to a further matching circuit 34 and to a further network 33, which also includes a printed inductor, a capacitor, which is connected to ground, and a resistor, which is connected to the positive voltage U + .

The matching circuit 34 connects the drain of HEMT 34 to a diplexer, which separates the IF1 and LO1 frequencies. The diplexer is realised by two four-section parallel coupled printed microstrip lines bandpass filters. The measured conversion gain of the mixer was 6,0 dB with a noise figure less than 6 dB.

In the preferred embodiment for the HEMTs 19, 20, 30 the MITSUBISHI device MGF 4317C, which is a 0,25 um gate length InGaAs HEMT and marketed in a 70 mil stripline package for 12 GHz DBS applications, was taken. These transistors are specified to have a typical noise figure of 0,65 dB with an associated gain of 12 dB at 12 GHz.

The LNA 11, realised in the two stage design with microstrip matching and DC bias circuits printed on a 0,4 mm thick teflon-glass substrate, can be realised with standard photolithographic techniques. The measured performance of the LNA 11 shows a gain of more than 22 dB and a noise figure less than 1,6 dB over the band 21,4 to 22,0 GHz.

The second mixer 15 is included in a GaAs monolithic microwave integrated circuit (MMIC) 15', such as the ANADIGICS device AKD 12000 downconverter MMIC. This MMIC 15' also includes an amplifier at the signal input frequency, an amplifier at the intermediate frequency, a local oscillator transistor and filters.

The local oscillator 14 used in this embodiment is the MURATA device MQB 007 DRO, which is a commercially available dielectric resonator oscillator (DRO) and marketed in a hermetically sealed package for 12 GHz applications.

Between the oscillator 14 and the mixers 13, 15 a microstrip divider 35 is provided.

Using the aforementioned circuits a prototype downconverter has been built with a gain in excess of 55 dB and a noise figure less than 1,8 dB over the band 21,4 to 22,0 GHz.

Fig. 3 and 4 show a second embodiment using a single mixer which is subharmonically pumped by a local oscillator. Means and signals with the same meaning and functions as in the first embodiment have the same refernce numbers and they will be only explained as far as it is necessary for the understanding of the invention.

The microwave signals filtered by the first bandpass filter 12 are led to a subharmonic mixer 100. This mixer receives also the local oscillator signals LO1 from the local oscillator 14. Thereby signals IF2 in the second intermediate band (1,1 - 1,7 GHz) are generated which can be amplified by an amplifier 101. Output of this amplifier 101 is connected via the output terminal 16 to further means, e.g. indoor units, of a DBS system.

Fig. 4 shows details of the subharmonic mixer 100. The signal from the filter 12 is led via a matching circuit 102 and a capacitor 103 to a connection point. The local oscillator signal LO1 is led via a further matching circuit 108, a antiparallel pair of Schottky diodes 106, 107, and a further matching circuit 105 to the same connection point, which is further connected to a first side of a matching circuit 104, the other side of which is connected to the input of the amplifier 101.

In a prototype an antiparallel pair of GaAs Schottky diodes in a single beam-lead package (HEWLETT-PACKARD HSCH 9251) is used. This component is mounted in a microstrip circuit. Open circuit stubs are used to provide the necessary local oscillator and input signal short circuits at the diode and microstrip matching circuits are incorporated.

The configuration is such that the symmetrical properties of the diode pair suppress the fundamental mixing product and enhance the mixing of the input microwave signal with twice the local oscillator frequency which produces the desired IF2 signals. With a local oscillator drive level of 7,4 dBm the measured noise figure over the band is 6,5 dB.

Additionally it may be mentioned that matching circuits in both embodiments include appropriate means to short the local oscillator frequency or the input microwave signal frequency respectively.

Versions of the preferred embodiment may include at least one of the following variations:

- Instead of using one local oscillator 14, two may be used;
- instead of using the same local oscillator frequency for LO1 and for LO2, different frequencies may be used. According signals can be generated e.g by different local oscillators or by frequency dividers;
- the local oscillator may be built from discrete components such as a field effect transistor (FET) and dielectric resonator;
- the local oscillator 14 and the second mixer 15 could be realised as a single MMIC;
- one local oscillator may be used for LO1, while a dielectric resonator is coupled to the downconverter MMIC 15' to provide LO2;
- the second mixer 15 can be built by discrete components instead of a MMIC;
- other HEMTs or FETs or Schottky diodes could be used for the mixer 13;
- other HEMTs could be used for the LNA 11;
- other type of bandpass filter structure could be used e.g. interdigital lines, comb-lines

- LNA 11 and/or mixer 13 could be realised as MMICs;
- signals in the extra high frequency (EHF; 30-300 GHz) band, especially in the 44 GHz band, can be downconverted by using components which are available for processing signals of the 12 GHz or 22 GHz band.

The aim of both solutions of this invention is to achieve a good possible noise figure/gain combination whilst using only low-cost (packaged) devices.

Chebyshev response bandpass filters with two, three and four resonators have been designed and realised as parallel-coupled microstrip lines on the soft substrate. A two section filter is sufficient for the double down conversion topology as the image-rejection filtering requirement is not severe due to the large difference between the local oscillator signal and the input signal frequencies. The measured insertion loss for this filter over the 22 GHz band was 0,5 dB, with a return loss of grater than 15 dB.

For the single conversion configuration a four element design is required to achieve an image rejection in excess of 50 dB.

## Claims

1. Arrangement for downconverting received microwave signals, especially in the 22 GHz DBS band, with a mixer (13) to which according first local oscillator signals (LO1) are led, whereby the received signals are converted into a first intermediate frequency band (IF1), characterised in that a second mixer (15) is provided to which second local oscillator signals (LO2) are led and which converts the signals (IF1) of the first intermediate frequency band into a second intermediate frequency band (IF2).

2. Arrangement according to claim 1, characterised in that the first intermediate frequency band (IF1) lies within the 12 GHz DBS frequency range and that the second intermediate frequency band (IF2) is compatible with indoor units of a DBS system.

3. Arrangement according to claim 1 or 2, characterised in that the first (LO1) and the second (LO2) local oscillator signals have essentially the same frequency.

4. Arrangement according to one of the claims 1 to 3, characterised in that the first (LO1) and the second (LO2) local oscillator signals are derived from the same local oscillator (14).

5. Arrangement for downconverting received microwave signals, especially in the 22 GHz DBS band, with a mixer (100) to which according first local oscillator signals (LO1) are led, whereby the received signals are converted into a intermediate frequency band (IF2), characterised in that the mixer (100) is realised as subharmonic mixer.

6. Arrangement according to claim 5, characterised in that the intermediate frequency band (IF2) is compatible with indoor units of a DBS system.

7. Arrangement according to one of the claims 1 to 6, characterised in that only packaged devices on a single printed circuit are used.

8. Arrangement according to one of the claims 1 to 7, characterised in that the received signals are in the extra high frequency (EHF) band.

FIG.1

FIG.3

FIG.4

FIG. 2